# EUROPÄISCHE PATENTSCHRIFT

(11) **EP 2 786 161 B1**
(45) Veröffentlichungstag und Bekanntmachung des Hinweises auf die Patenterteilung: **13.09.2023**
(21) Anmeldenummer: 12795384.2
(22) Anmeldetag: 21.11.2012
(51) Int. Cl.: G01R 29/18, H02J 3/26

(54) **SYSTEM VON VERNETZTEN HAUSGERÄTEN MIT EINER GEMEINSAMEN ZEITBASIS SOWIE EINER ERKENNUNGSEINRICHTUNG EINER BETREFFENDEN PHASE DER GEBÄUDEINSTALLATION, SOWIE VERFAHREN ZUM BETREIBEN EINES SOLCHEN SYSTEMS**
SYSTEM OF NETWORKED DOMESTIC APPLIANCES HAVING A JOINT TIME BASE AND IDENTIFICATION DEVICE OF A RESPECTIVE PHASE OF THE BUILDING INSTALLATION, AND METHOD FOR OPERATING SUCH A SYSTEM
SYSTÈME D'APPAREILS ÉLECTROMÉNAGERS MIS EN RÉSEAU PRÉSENTANT UNE BASE DE TEMPS COMMUNE ET UN DISPOSITIF DE DÉTECTION D'UNE PHASE CONCERNÉE DE L'INSTALLATION D'UN BÂTIMENT, ET PROCÉDÉ POUR FAIRE FONCTIONNER UN TEL SYSTÈME

(30) Priorität: 29.11.2011 DE 102011087280
(43) Veröffentlichungstag der Anmeldung: 08.10.2014
(73) Patentinhaber: BSH Hausgeräte GmbH, 81739 München (DE)
(72) Erfinder: GAUGLER, Johannes, 93073 Neutraubling (DE); KOLBE, Andreas, 12683 Berlin (DE); LEITL-NOBEL, Martin, 86465 Welden (DE); RANCK, Sharon, 89407 Dillingen (DE); SIPPEL, Matthias, 83329 Waging am See (DE)
(86) Internationale Anmeldenummer: PCT/EP2012/073154
(87) Internationale Veröffentlichungsnummer: WO 2013/079367

(56) Entgegenhaltungen:
- EP-A1- 2 388 600
- EP-A2- 2 071 693
- WO-A2-2010/027421
- DE-A1- 4 405 809
- DE-C2- 19 502 786
- US-A1- 2004 263 147
- US-A1- 2010 262 393

## Beschreibung

Die Erfindung betrifft ein System von vernetzten Hausgeräten, insbesondere eines Systems für ein Management, im ganz Besonderen eines Energiemanagements, mit insbesondere einer übergeordneten Einheit zur Ausführung des Managements, wobei jedes Hausgerät eine Erkennungseinrichtung einer betreffenden Phase eines Drehstromnetzes der zugrundeliegenden Gebäudeinstallation aufweist.

Die Erfindung betrifft ferner ein Verfahren zum Betreiben eines solchen Systems.

Hausgeräte werden in progressiver Ausrichtung zunehmend als untereinander drahtgebunden oder drahtlos vernetzt eingesetzt. Dabei werden wichtige Informationen als digitale Daten, wie insbesondere als Datenpakete ausgetauscht, wobei der Datenaustausch im Wesentlichen durch eine übergeordnete, systembezogene Einheit erfolgt, die meist zur Berücksichtigung günstiger, abzurechnenden Energiekosten gegenüber einem Energieversorgungsunternehmen deren Management ausführt. Dafür wird üblicherweise auch die Abkürzung HEMS verwendet, wofür die englischsprachigen Begriffe "Home Energy Management System" (Haushalts-bezogenes Energie-Management-System) stehen. Das übergeordnete Management kann auch andere Gesichtspunkte als die Optimierung des Einsatzes von Energie und der gegenüber einem Versorgungsunternehmen abzurechnender Energie betreffen, da gegebenenfalls eine nur zeitweise zur Verfügung stehende Energiemenge von einem dezentralen Energieerzeuger in einem Haushalt zu verbrauchen ist.

Hausgeräte im Sinne der Erfindung sind im Wesentlichen Haushaltsgroßgeräte, wie Geschirrspüler, Herde, Kühlschränke, Bügel-Mulden, Waschmaschinen und Wäschetrockner. Sie sind für einen Haushalt betrachtet Energiegroßabnehmer mit einer Anschlussleistung von mehreren hundert bis über zwei Kilowatt. Ist die genaue Leitungsführung von Energieversorgungsleitungen im einem Haushalt nicht mehr bekannt, so kann es bei Neuausrüstung dieses Haushaltes mit Hausgeräten der angegebenen Art, wenn deren Aufstellung sowie deren elektrischer Anschluss vorgenommen wird, vorkommen, dass es zu einer Überlastung einer Phase einer zu dem betreffenden Haushalt gehörenden Mehr- bzw. Drehstromleitungsnetzes kommen kann. In der Regel werden Hausgeräte einphasig, also zwischen einem Drehstromleiter (R, S, T bzw. L1, L2, L3) bzw. einer Phase und einem Mittelpunktsleiter MP oder Neutralleiter N angeschlossen. Die Belastung der einzelnen Phasen sollte schon deshalb einigermaßen gleich sein, damit, der Neutralleiter nicht zu sehr durch Ausgleichsströme belastet ist, da dafür ein Hausinstallationsnetz meist nicht ausgelegt ist. Daneben sollte der pro Phase gezogene Strom einen Höchstwert nicht überschreiten, da sonst eine der Phase zugeordnete Sicherung bzw. ein Sicherungsautomat anspricht oder eine thermische Überlastung des elektrischen Hausinstallationsnetzes eintritt, wenn die Absicherung nicht richtig ausgelegt war.

Aus der DE 196 21 543 A1 ist ein Verfahren und eine Vorrichtung zur Phasenzuordnung bei einem mehrphasigen Energieversorgungsnetz, insbesondere eines Niederspannungsnetzes bekannt. Eine zunächst nicht zuordenbare Phase der Mehrphasennetzes wird identifiziert, indem ein Lastmodifikationsmodul eine Be- und Entlastung vornimmt und mit einem mehr- oder dreiphasig angeschlossenen Laststeuerungsmodul über einen Datenbus in Verbindung steht. In einer Ausführungsform dieser DE 196 21 543 A1 werden in dem Laststeuerungsmodul die Energiebilanzen allen drei Phasen miteinander verglichen, so dass es leicht möglich ist, die Phase zu ermitteln, die gerade durch das Lastmodifikationsmodul mit einer Be- und Entlastung beaufschlagt worden ist. Es ist jedoch als nachteilig anzusehen, dass die einzelne Phase, die erkannt werden soll, zunächst beund entlastet werden muss, da damit Störungen in Bereich von Funkfrequenzen ausgelöst werden können, die meist unerwünscht sind. Die DE 196 21 543 A1 sieht auch die Möglichkeit vor, die zur Phasenerkennung vorgesehenen Module in ein Hausgerät einzubauen, um bei dessen Anschluss an eine Steckdose die Phase erkennen zu können. Mit der richtigen Phasenerkennung aufgrund dieser DE 196 21 543 A1 soll es möglich werden, dass eine Hausleittechnik mit zugehörigem Lastmanagement funktionsgerecht betrieben werden kann. Es ist jedoch nicht vorgesehen, dass eine Hausleittechnik mit zugehörigem Lastmanagement selbst mit einer Möglichkeit zur Ermittlung der Phase eines anzuschließenden Hausgerätes versehen ist.

Durch die DE 195 02 786 C2 wird eine Schaltungsanordnung und ein Verfahren vorgeschlagen um an einem Versorgungsnetz angeschlossene Geräte gezielt mit Spannung zu versorgen. Dabei ist einem einzelnen Gerät, das an einer Phase eines Mehr- bzw. Dreiphasenetzes angeschlossen ist, ein Controller zugeordnet, der es ermöglicht, die elektrische Verbindung des Gerätes zur jeweiligen Phase aufrechtzuerhalten oder zu unterbinden. Es soll nach der DE 195 02 786 C2 ein Spitzenlastmanagement durchgeführt werden können, wobei der dem Gerät zugeordnete Controller unterscheidet, ob es für ein Haus-Gerät, bezogen auf dessen Funktion möglich ist, eine Einschaltung zeitlich zu verschieben, ohne dass die Lebensgewohnheiten des Benutzers dieses Gerätes beeinträchtigt werden.

Die WO 2010/027421 A2 offenbart ein Lastbalancierungsverfahren in einem Weitverkehrsstromnetz. Kundenendpunktknoten werden miteinander koordiniert, um eine gleichmäßige Lastverteilung zu erreichen. Hierfür werden unter anderem ein zentrales Verfahren und ein dezentrales Verfahren vorgestellt. Während für eine Phasenzuordnung der Kundenendpunkte beim zentralen Verfahren Zeitstempel zum Einsatz kommen, benutzt der dezentrale Ansatz eine Latenzaggregation, um ohne globale Zeit auszukommen.

Die EP 2 071 693 A2 beschäftigt sich mit der Frage, wie der Gleichstrom einer Photovoltaikanlage unter Vermeidung von Lastschieflagen durch die Steuerung der Wechselrichter in die unterschiedlichen Phasen eines Mehrphasenspannungsnetzes eingespeist werden kann. Die Einspeiseentscheidung wird dabei immer durch eine zentrale Steuereinrichtung getroffen.

EP 2 388 600 A1 offenbart ein System, das eine Stromverteilungsstation umfasst, die so ausgelegt ist, dass sie zu einem bestimmten Zeitpunkt ein eingespeistes Signal erzeugt und Spannung und das eingespeiste Signal überträgt, sowie eine Phasenerkennungsvorrichtung, die geeignet ist, die Spannung und das eingespeiste Signal zu empfangen, und eine Phase der empfangenen Spannung auf der Grundlage der Beziehung zwischen der empfangenen Spannung und dem eingespeisten Signal zu bestimmen.

Die Aufgabe der Erfindung besteht daher darin, bei Zugrundelegung eines Systems von verrietzten Hausgeräten eine Erkennungseinrichtung für eine Phase, an der ein einzelnes Hausgerät anschließbar ist, anzugeben, ohne dass Funkstörungen auftreten.

Die Erfindung wird durch die Gesamtheit der im unabhängigen Anspruch angegebenen und auf ein System gerichteten Merkmale gelöst und durch die auf diesen Anspruch rückbezogenen, abhängigen Ansprüche weitergebildet.

Entsprechendes gilt für die im weiteren, unabhängigen Anspruch angegebenen und auf ein Verfahren gerichteten Merkmale.

Die Erfindung betrifft also ein System von vernetzten Hausgeräten, das ein neu zum Anschluss anstehendes Hausgerät umfasst, das vorläufig angeschlossen ist, wobei jedes Hausgerät eine Erkennungseinrichtung einer betreffenden Phase eines Drehstromnetzes der zugrundeliegenden Gebäudeinstallation aufweist, wobei die im System befindlichen Hausgeräte eine gemeinsame Zeitbasis aufweisen, wobei die Erkennungseinrichtung jedes Hausgerätes eine Zeitmesseinrichtung aufweist, um eine positive Flanke eines Nulldurchgangs einer am Hausgerät angelegten Versorgungsspannung in Bezug auf ein Sprungsignal, das allen Hausgeräten des Systems einschließlich des vorläufig angeschlossenen Hausgeräts übermittelbar ist, messbar zu machen, wobei die Erkennungseinrichtung einen Phasenzuordner aufweist, der ein Ergebnis der Zeitmessung der Zeitmesseinrichtung so auswertbar macht, dass die zutreffende Phase, an der jedes Hausgerät angeschlossen ist, ermittelbar und anzeigbar ist, um eine phasenbezogene Überlast erkennbar zu machen.

Dadurch, dass nach der Erfindung die Erkennung der Phasen an denen ein hinzukommendes Hausgerät oder bereits angeschlossene Hausgeräte betrieben werden, durch vom Energienetz abgeleiteten Informationen erfolgt und dabei das Energienetz nicht selbst belastet wird, sind keine Störungen, die Funknetze beeinflussen könnten, zu erwarten. Ferner bringt die Erkennung der Phasen durch vom Energienetz abgeleitete Informationen noch den besonderen Vorteil, dass keine phasenbezogene Überlast, wie bei dem Lastmodifikationsmodul nach der DE 196 21 543 A1, entstehen kann. Dabei ist es des Weiteren sehr förderlich, dass in den Erkennungseinrichtungen aller Hausgeräte die gleiche Zeitbasis vorliegt, da damit ein eindeutiger Bezug zur Ausmessung der Nulldurchgänge der Phasenspannungen für jeweils angeschlossene Hausgeräte möglich ist.

Da die Hausgeräte vernetzt sind, bietet es sich an, dass die Erkennungseinrichtung in einem jedem Hausgerät zugeordneten Interface mit integriert ist. Das Interface jedes Hausgerätes wird ohnehin für den Datenaustausch des HEMS benötigt und ist insofern gut geeignet, weitere Funktionen zu übernehmen.

Die Vernetzung für diesen Datenaustausch erfolgt drahtlos oder draht- bzw. leitungsgebunden. Bei drahtloser Übertragung wird ein lokales Netz mit Funkfrequenzen im Gigahertzbereich, wie WiFi oder ZigBee herangezogen werden. Eine drahtgebundene Vernetzung kann über das Energieversorgungsnetz selbst mittels Powerline oder über eine Leitung nach einem Übertragungsstandard, wie Ethernet, erfolgen.

Soweit die Interface-Einheiten für einen Datenaustausch mit einer Einheit des Systems für ein Hausgeräte-Management bzw. HEMS dienen, steht zwar primär ein Energiemanagement an. Es können jedoch auch andere Aufgaben mit ausgeführt bzw. zugelassen werden.

So steht es an, dass eine jeweilige Uhr einer Interface-Einheit in Bezug auf alle anderen Uhren synchronisiert werden kann.

Dabei wird zur Synchronisierung der Uhren ein Synchronisierungs-Algorithmus herangezogen, wie er dem Network-Time-Protokoll (NTP) oder dem Precision-Time-Protokoll (PTP) entspricht.

Um den Steuerungsablauf bestimmungsgemäß ausführen zu können, weist die Interface-Einheit von jedem Hausgerät die Zeitmess-Schaltung, eine Zuordner-Schaltung für die Phasen-Zuordnung und einen Ausgabeteil mit Display auf, wobei das Display auch noch mit Displaytasten versehen wird.

Es hat sich als günstig herausgestellt, wenn im Anzeigeteil einer Interface-Einheit oder in den Anzeigeteilen aller Interface-Einheiten die zutreffende Phase angezeigt wird. Nur so kann ein Benutzer umfassend über die Anschlüsse der Hausgeräte bezogen auf die einzelnen Phasen informiert werden.

Besonders ist es zu bevorzugen, wenn für einen Benutzer nach Betätigung betreffender Displaytasten Prognosewerte über Belastungen einzelner Phasen in Relation zur Absicherung abgerufen werden können und auf dem Display dargestellt werden können. Es können dann auch sogenannte "worst case" Szenarien in der Belastung einzelner Phasen erkannt werden und evtl. eine andere Anschlussreihenfolge der Hausgeräte in Bezug auf das Energienetz des betreffenden Haushaltes vorgenommen werden.

Bei dem Verfahren zum Betreiben des zuvor beanspruchten Systems wird vorgesehen, dass die zum System gehörige Erkennungseinrichtung folgende Schritte durchführt: Herstellung einer gemeinsamen Zeitbasis für alle vernetzten Hausgeräte, Auslösung eines Sprungsignals für alle vernetzten Hausgeräte einschließlich des vorläufig angeschlossenen Hausgeräts, Einleitung eines Zeitmessvorganges ab dem Sprungsignal in Bezug auf eine zuzuordnende positive Flanke eines Impulsverlaufes eines Nulldurchgangssignals einer Phase, Auswertung des Messvorganges und Zuordnung der kürzesten Messzeit für die Phase L1, einer mittleren Messzeit für die Phase L2 und einer längsten Messzeit für die Phase L3 und Anzeige der Phasenzuordnung in Bezug auf das Hausgerät von dessen Erkennungseinrichtung der Phasen-Erkennungsvorgang initiiert wurde, um eine phasenbezogene Überlast erkennbar zu machen. Es ist jedoch auch möglich die Phasenzuordnung der anderen Hausgeräte in Bezug auf deren Erkennungseinrichtung bzw. deren Interface anzuzeigen bzw. einer Erkennungseinrichtung bzw. einem Interface eines Hausgerätes alle Anzeigefunktionen zu übertragen.

Soweit die Erfindung durch auf die unabhängigen Ansprüche rückbezogene, nicht selbständige Ansprüche weitergebildet wird, so soll es so sein, dass eine zunächst angegebene Kette von Rückbeziehungen nicht einschränkend in Bezug auf die insgesamt mitgeteilte Lehre zu sehen ist, soweit auch andere Kombinationen von Merkmalen von Ansprüchen sich als geeignet und ausführbar aus Sicht des Fachmanns ergeben.

Im Folgenden wird die Erfindung anhand von Ausführungsbeispielen schematisch genauer beschrieben. Gleiche Bezugszeichen zeigen gleiche oder vergleichbare Teile. Die Figuren werden zunächst kurz erläutert:
Fig. 1 zeigt ein Übersichtsschaltbild eines Systems von vernetzten Hausgeräten, die ver- . teilt an einzelne Phasen eines Drehstromnetzes in Bezug auf einen Neutralleiter angeschlossen sind, wobei ein einzelnes Hausgerät noch anschließbar ist,
Fig. 2 zeigt wichtige Signalverläufe bei einem Steuerungsablauf zur Phasenerkennung,
Fig. 3 zeigt ein Blockschaltbild eines Interface eines Hausgerätes mit Einrichtungen für die Phasenerkennung.

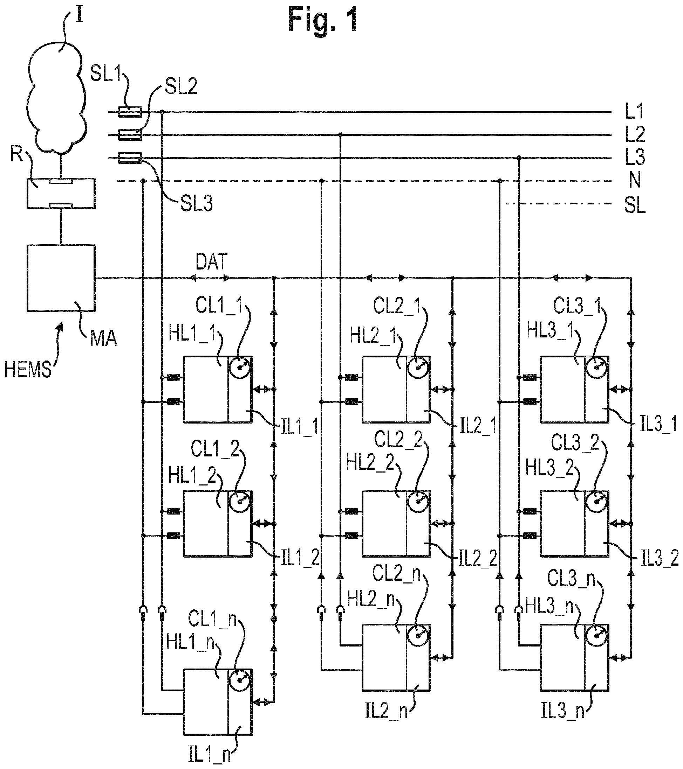

Ein System mit vernetzten Hausgeräten geht aus der Fig. 1 hervor. Dabei steht meist ein systembezogenes Energiemanagement (Home Energy Management System, HEMS) zur Realisierung an. Eine Steuerungseinheit für das Energiemanagement ist mit MA bezeichnet. Diese Einheit MA kann auch Informationen aus dem Internet I oder einem Smart Grid berücksichtigen, die über einen Router R der Einheit MA zugeführt werden. Die Einheit MA ist drahtgebunden oder drahtlos mit allen Hausgeräten des Systems vernetzt. Für eine drahtlose Vernetzung dieser Hausgeräte kann ein lokales Netz mit Funkfrequenzen im Gigahertzbereich, wie WiFi oder ZigBee herangezogen werden. Eine drahtgebundene Vernetzung kann über das Energieversorgungsnetz selbst mittels Powerline oder über eine Leitung nach einem Übertragungsstandard, wie Ethernet, erfolgen. Die Vernetzung der Hausgeräte zum Datenaustausch DAT ist auch dann vorliegend, wenn die Hausgeräte, die nachfolgend noch bezüglich ihrer Anschluss-Systematik beschrieben werden, nicht betrieben werden oder deren Bereitschaftstellung für einen in Kürze erfolgenden Betrieb, auslöst über das systemgebundene Energiemanagement, erfolgen soll.

In weiterer Darstellung zeigt Fig. 1 wie die Hausgeräte des HEMS jeweils einphasig entsprechend der Installation des zugrundeliegenden Gebäudes bzw. des Haushaltes, in dem die Hausgeräte betrieben werden, angeschlossen sind. Dem Haushalt ist ein dreiphasiges Netz, bzw. Drehstromnetz mit den Außenleitern L1, L2, L3 einem Neutralleiter N und einem Schutzleiter SL zugeführt. Jeder Leiter ist durch eine Sicherung oder einen Sicherungsautomat abgesichert, also SL1, SL2, SL3. Die Hausgeräte werden, wie dargelegt einphasig, also zwischen einem Außenleiter und dem Neutralleiter N angeschlossen. Entsprechende Steckerbuchsen sind der Übersichtlichkeit halber nicht eingezeichnet. Es sind lediglich die Anschluss-Steckpunkte hervorgehoben. Ebenso ist der Anschluss des Schutzleiters weggelassen worden. An der Phase L1 sind die Hausgeräte HL1_1, HL1_2 und HL1_n angeschlossen, wobei es sich bei HL1_n um ein Hausgerät handelt, das gerade angeschlossen werden soll. An der Phase L2 sind die Hausgeräte HL2_1. HL2_2 und HL2_n angeschlossen. An der Phase L3 sind es die Hausgeräte HL3_1, HL3_2 und HL3_n. Jedes Hausgerät besitzt ein Interface, wie IL1_1 für HL1_1, usw. bis IL3_n für HL3_n. Damit kann über eine drahtlose Verbindung oder über eine draht- bzw. leitungsgebundene Verbindung der Datenaustausch der Hausgeräte, soweit erforderlich untereinander, jedoch überwiegend unter den Vorgaben von HEMS mit der Einheit MA erfolgen.

Für die Erfindung ist es hervorzuheben, dass im Interface jedes Hausgerätes eine Uhr C aufgenommen ist. Dabei werden Bezeichnungen CL1_1 für das Interface IL1_1 usw. bis CL3_n für das Interface IL3_n vorgesehen. Die Uhren CL1_1 bis CL3_n aller Hausgeräte sind untereinander in sehr hochgenauer Weise synchronisiert. Es ist von einer Genauigkeit untereinander von 2,5 ms bis 0,05 ms, bevorzugt von 0,25 ms auszugehen, so dass 45° bis 1°, bevorzugt 4,5° Phasenunterschied bezogen auf ein 50 Hz Drehstromnetz ohne Weiteres erkennbar ist. Um die Uhren untereinander zu synchronisieren, wird ein Synchronisierungs-Algorithmus verwendet, dessen Ablauffolge beispielsweise in der Einheit MA gespeichert ist. Als Synchronisierungs-Algorithmus kann ein Algorithmus gewählt werden, wie er dem Network-Time-Protokoll (NTP) oder dem Precision-Time-Protokoll (PTP) entspricht.

Wie eingangs bereits dargelegt, ist von einer Konstellation auszugehen, nach der ein Haushalt mit neuen- netzwerkfähigen - Hausgeräten, auszurüsten ist, bei dem jedoch keine ausreichende Dokumentation der elektrischen Stromleitungen vorliegt.

In Fig. 1 ist ein Hausgerät, nämlich HL1_n in leicht abgesetzter Weise dargestellt. Es könnte sich jedoch auch um ein Hausgerät, wie HL2_n bzw. HL3_n handeln, das hinzukommend zu bereits angeschlossenen Hausgeräten (HL1_1, HL1_2; HL2_1, HI2_2; HL3_1, HL3_2), die meist noch keine unzulässig hohe Belastung für eine der Phasen L1, L2 und L3 des Energieversorgungs- bzw. der Stromleitungen in dem betreffenden Haushalt darstellen und somit keiner der Sicherungsautomaten SL1, SL2 oder SL3 sich an der Auslösegrenze befindet. Es ist im Regelfall sogar davon auszugehen, dass pro Phase die Belastung durch bereits angeschlossene Hausgeräte unterschiedlich ist, so dass der Spielraum zur Auslösegrenze eines zugehörigen Sicherungsautomaten unterschiedlich hoch ist. Wenn ein weiteres Hausgerät n endgültig angeschlossen werden soll, ist es daher wichtig, herauszufinden, um welche der Phasen L1, L2 oder L3 es sich an der - in Aussicht genommenen - Anschluss-Stelle handelt.

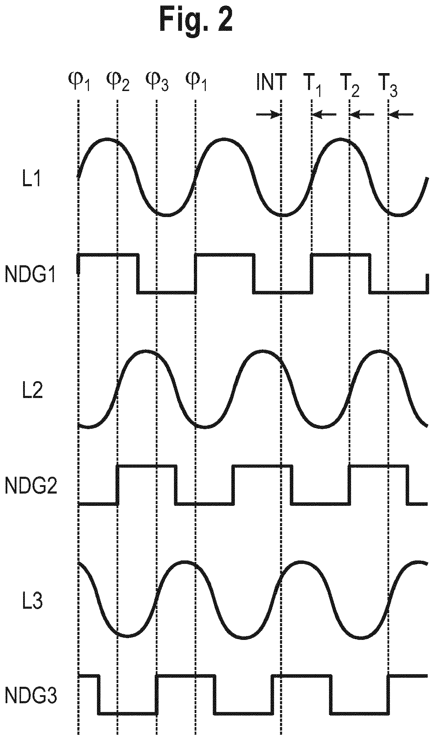

Eine Erkennung der Phase L1, L2 oder L3 an der das Hausgerät n bei einem versuchsweise vorgenommenen Anschluss an eine unbekannt in Bezug auf L1, L2 oder L3 Anschluss-Steckdose sich befindet, kann anhand der nachfolgend mit Fig.2 dargestellten Spannungsverläufe der drei Phasen L1, L2 und L3 und zugehöriger Nulldurchgangsverläufe NDG1, NDG2 und NDG3 ermittelt werden. Dazu ist zu berücksichtigen, dass der Phasenunterschied Δϕ der einzelnen Phasen zueinander bei dem primär der Hausinstallation zugeführten Drehstromnetz jeweils 120° beträgt, d.h. in Bezug auf die Einträge in Fig. 2: ϕ₁ = 0°, ϕ₂ = 120°und ϕ₃ = 240°. Es wird davon ausgegangen, dass Hausgeräte an den Phasen L1, L2, L3, die bereits fest angeschlossen sind, sich in irgendeiner Weise im Betrieb befinden. Wird das Hausgerät n an eine unbekannt in Bezug auf L1, L2 oder L3 vorliegende Anschluss-Steckdose versuchsweise angeschlossen, so kann durch eine erfindungsgemäß ausgelöste Ablauffolge die zugehörige Phase des herangezogenen Anschlusses erkannt werden. Es wird hierfür ein IInterrupt INT ausgelöst, der in Fig. 2 kenntlich gemacht ist. Dann wird die Zeit bis zum nächsten Nulldurchgang der Leiter der Phasen L1, L2, und L3 gemessen. Es wird auf die Nulldurchgangs-Impulsfolge NDG1, NDG2 und NDG3 der Fig. 2 verwiesen. Liegt ein Anschluss des Hausgerätes n an der Phase L1 vor, so liegt die Zeit T₁ bis zum Nulldurchgang, erkenntlich an der positiven Flanke von Impulsverlauf NDG1 vor. Liegt ein Anschluss des Hausgerätes an der Phase L2 vor, so liegt die Zeit T₂ bis zum Nulldurchgang, erkenntlich an der positiven Flanke von Impulsverlauf NDG2 vor. Liegt ein Anschluss des Hausgerätes an der Phase L3 vor, so liegt die Zeit T₃ bis zum Nulldurchgang, erkenntlich an der positiven Flanke von Impulsverlauf NDG3 vor. Es ist zu erkennen, dass hierbei T₁ < T₂ < T₃ ist. Dieser Vergleich ist möglich, da die Hausgeräte untereinander vernetzt sind. Das Ergebnis T₁ oder T₂ oder T₃ steht im Interface I...n des Hausgerätes n zur Verfügung.

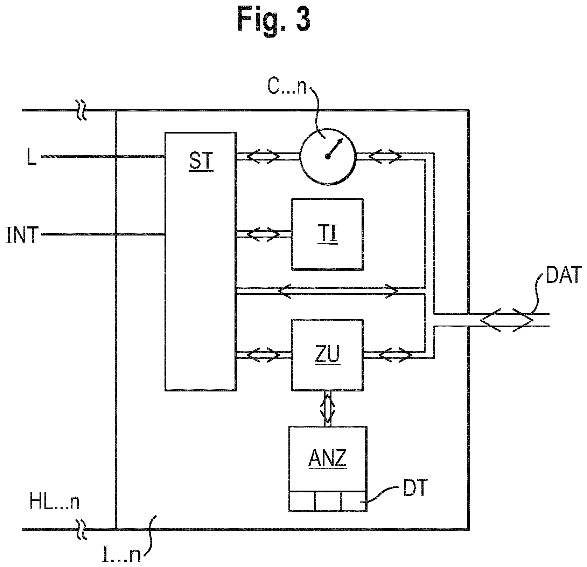

Mit Fig. 3 wird ein Blockschaltbild eines bevorzugten Aufbaues des Interface, wie beispielsweise I...n für ein Hausgerät H...n schematisch gezeigt. Eine Steuerungseinheit ST empfängt einerseits ein potentialgetrenntes Abbild der Phasenspannung L, deren Zuordnung zu L1, L2 oder L3 noch nicht bekannt ist. Andererseits empfängt die Steuerungseinheit ST ein Signal der internen Uhr C des Interface. Die Uhr C des Interface ist über einen der zuvor benannten und an sich bekannten Synchronisations-Algorithmus mit den Uhren der Interface-Teile der anderen Hausgeräte synchronisiert. Ein Interrupt INT kann an dem Interface des dazugehörigen Hausgerätes oder zentral an der Einheit MA des HEMS ausgelöst werden. Mit einer Zeitmess-Schaltung TI wird nach einem ausgelösten Interrupt die der positiven Flanke des Impulsverlaufes NDG entsprechende Zeit T ermittelt. Über eine Zuordner Schaltung ZU kann je nach gemessener Zeit T₁ oder T₂ oder T₃ ermittelt werden, an welcher Phase L1 oder L2 oder L3 das betreffende Hausgerät - zumindest vorläufig- angeschlossen ist. Dabei wird, soweit erforderlich, ein Datenaustausch über die drahtlose oder draht- beziehungsweise leitungsgebundene Vernetzung mit den Interface-Teilen der anderen Hausgeräte vorgenommen. Insbesondere ist es wichtig, dass potentialgetrennte Abbildungen der anderen Phasen, der sonst noch angeschlossenen und vernetzten Hausgeräte über deren Interface-Teile mit ausgewertet werden. Das Ergebnis der ermittelten Phase L1 oder L2 oder L3 wird in einem Ausgabeteil ANZ, wie einem Display des Interface I..n des neu zum Anschluss anstehenden Hausgerätes angezeigt. Da ein beschriebenes Interface in gleicher Weise den bereits - schon längere Zeit- angeschlossenen Hausgeräten zugeordnet ist, ist es auch möglich, an den Interface-Teilen der anderen Hausgeräte die ermittelte Phase anzuzeigen. Damit können, falls noch nicht bekannt, auch die Phasenanschlüsse der bereits seit längerer Zeit angeschlossenen Hausgeräte ermittelt werden und eine Kontrolle hinsichtlich bereits getroffener Anschlüsse von Hausgeräten ausgeübt werden.

Es ist auch hervorzuheben, dass ein einzelnes Interface, wie in Fig. 3 dargestellt, über dem Display der Anzeige ANZ zugeordnete Displaytasten DT verfügt. Damit können nach einem Phasen-Feststellvorgang auch andere wichtige Kontrollen bezüglich des Energienetzes, an dem die Hausgeräte in Bezug auf einen Haushalt angeschlossen sind (bzw. zum endgültigen Anschluss anstehen) durchgeführt werden. So kann beispielweise ermittelt und angezeigt werden, ob die pro Phase angeschlossenen Hausgeräte eine Belastung darstellen, die in Bezug auf die Absicherung durch einen Sicherungsautomaten pro Phase noch zulässig sind. Da ein Belastungsverhalten eines jeweiligen Hausgerätes über einen Arbeitszyklus an sich bekannt ist, ist es auch möglich eine Prognose abzugeben, ob in einem "worst case" eine möglicherweise auftretende Belastungsspitze aller, insbesondere pro Phase angeschlossenen Hausgeräte, ein Sicherungsautomat SL1 bis SL3 evtl. auslöst oder ob dies gerade nicht der Fall sein wird. Hierzu ist eine Darstellung auf dem Display der Anzeige ANZ sehr förderlich, da damit auch sehr zeitkritische Belastungen dargestellt werden können. Kontrollen dieser Art werden in bevorzugter Weise durch die Betätigung der benannten Displaytasten DT vorgenommen.

Es versteht sich von selbst, dass die Kontrollen, die nach Ermittlung der betreffenden Phase eines Hausgerätes vorgenommen werden können, sowohl bezogen auf ein dem entsprechenden Interface zugehörigen Hausgerät als auch für alle Hausgeräte vorgenommen werden können. Soweit es sich jedoch um Kontrollen handelt, die mehr übergeordneten Charakter haben, bietet es sich jedoch an, eine Schaltungsanordnung, wie anhand der Fig. 3 beschrieben, auch in die Einheit MA mit aufzunehmen, um an zentraler Stelle diese beispielhaften Kontrollaufgaben vornehmen zu können oder das Management so zu gestalten, dass keine unzulässigen Belastungsspitzen pro Phase auftreten. Dabei kann für die Schaltungsanordnung, wie sie anhand von Fig. 3 durch einzelne Schaltungsteile beschrieben ist, auch davon ausgegangen werden, dass die Funktionen, die von einzelnen Schaltungsteilen ausgeübt werden, auch von einer rechnenden Anordnung realisiert werden, die durch ein technisches Programm betrieben wird, dessen Ablauffolge in einem Speicher dieser rechnenden Schaltungsanordnung (dauerhaft) gespeichert sind. Insofern ist es dann auch einfach möglich, den Funktionsumfang der Schaltungsanordnung nach Fig. 3 in der Einheit MA des HEMS aufzunehmen.

### Bezugszeichenliste

- HEMS: systembezogenes Energiemanagement für Haushalt
- MA: Einheit für HEMS
- I: Internet (auch Smart Grid)
- R: Router
- DAT: Datenaustausch über Netz der vernetzten Hausgeräte
- L1: Außenleiter R von Drehstromnetz (an Einführungsstelle Haushalt)
- L2: Außenleiter S von Drehstromnetz (an Einführungsstelle Haushalt)
- L3: Außenleiter T von Drehstromnetz (an Einführungsstelle Haushalt)
- N: Neutralleiter, Mittelpunktsleiter MP
- SL: Schutzleiter
- HL1_1: Hausgerät 1 an Phase L1 (gegen N)
- HL2_1: Hausgerät 1 an Phase L2 (gegen N)
- HL3_1: Hausgerät 1 an Phase L3 (gegen N)
- HL1_n: Hausgerät n an Phase L1 (gegen N)
- HL2_n: Hausgerät n an Phase L2 (gegen N)
- HL3_n: Hausgerät n an Phase L3 (gegen N)
- IL1_1: Interface von HL1_1
- IL3_n: Interface von HL3_n
- CL1_1: Uhr von lL1_1
- CL3_n: Uhr von lL_n
- SL1: Sicherungsautomat von Leiter L1
- SL2: Sicherungsautomat von Leiter L2
- SL3: Sicherungsautomat von Leiter L3
- NDG1: Nulldurchgangsverlauf digital von Spannung an L1 (Impulsverlauf)
- NDG2: Nulldurchgangsverlauf digital von Spannung an L2 (Impulsverlauf)
- NDG3: Nulldurchgangsverlauf digital von Spannung an L3 (Impulsverlauf)
- ϕ: Phasenwinkel
- INT: Interrupt
- TI: Zeitmess-Schaltung
- ZU: Zuordner
- AUZ: Ausgabeteil (mit Display)
- DT: Displaytasten

## Patentansprüche

1. System von vernetzten Hausgeräten, das ein neu zum Anschluss anstehendes Hausgerät umfasst, das vorläufig angeschlossen ist, wobei jedes Hausgerät eine Erkennungseinrichtung einer betreffenden Phase eines Drehstromnetzes der zugrundeliegenden Gebäudeinstallation aufweist, **dadurch gekennzeichnet, dass** die im System (HEMS) befindlichen Hausgeräte (HL1_1 - HL3_n) eine gemeinsame Zeitbasis (CL1_1 - CL3_n) aufweisen, wobei die Erkennungseinrichtung (IL1_1 - IL3_n) jedes Hausgerätes eine Zeitmesseinrichtung (TI) aufweist, um eine positive Flanke eines Nulldurchgangs (NDG1 - NDG3) einer am Hausgerät angelegten Versorgungsspannung in Bezug auf ein Sprungsignal (INT), das allen Hausgeräten des Systems einschließlich des vorläufig angeschlossenen Hausgeräts übermittelbar ist, messbar zu machen, wobei die Erkennungseinrichtung (IL1_1 - IL3_n) einen Phasen-Zuordner (ZU) aufweist, der ein Ergebnis der Zeitmessung der Zeitmesseinrichtung (TI) so auswertbar macht, dass die zutreffende Phase, an der jedes Hausgerät angeschlossen ist, ermittelbar und anzeigbar (ANZ) ist, um eine phasenbezogene Überlast erkennbar zu machen.

2. System nach Anspruch 1, **dadurch gekennzeichnet, dass** die Erkennungseinrichtung mit einem jedem Hausgerät (HL1_1 - HL3_n) zugewiesenen Interface (IL1_1 - IL3_n) ausbildbar ist.

3. System nach Anspruch 1 oder 2, **dadurch gekennzeichnet, dass** die Interface-Einheiten (IL1_1 - IL3_n) aller Hausgeräte drahtlos oder draht- bzw. leitungsgebunden miteinander für einen Datenaustausch (DAT) vernetzt sind.

4. System nach Anspruch 3, **dadurch gekennzeichnet, dass** die Interface-Einheiten (IL1_1 - IL3_n) auch für einen Datenaustausch (DAT) mit einer Einheit (MA) eines Systems für ein Hausgeräte-Management vernetzt sind.

5. System nach Anspruch 3 oder 4, **dadurch gekennzeichnet, dass** eine jeweilige Uhr (CL1_1 - CL3_n) einer Interface-Einheit (IL1_1 - IL3_n) in Bezug auf alle anderen Uhren (CL1_1 - CL3_n) synchronisierbar ist.

6. System nach Anspruch 5, **dadurch gekennzeichnet, dass** zur Synchronisierung der Uhren (CL1_1 - CL3_n) ein Synchronisierungs-Algorithmus heranziehbar ist, wie er dem Network-Time-Protokoll (NTP) oder dem Precision-Time-Protokoll (PTP) entspricht.

7. System nach einem der vorhergehenden Ansprüche, **dadurch gekennzeichnet, dass** eine Interface-Einheit (IL1_1 - IL3_n) die Zeitmess-Schaltung (TI), die Zuordner-Schaltung (ZU) und den Ausgabeteil (ANZ) mit Display aufweist, wobei das Display Displaytasten (DT) aufweist.

8. System nach Anspruch 7, **dadurch gekennzeichnet, dass** im Anzeigeteil (ANZ) einer Interface-Einheit (IL1_1 - IL3_n) oder in den Anzeigeteilen (ANZ) aller Interface-Einheiten (IL1_1 - IL3_n) die zutreffende Phase anzeigbar ist.

9. System nach Anspruch 7 oder 8, **dadurch gekennzeichnet, dass** über die Displaytasten (DT) Prognosewerte über Belastungen einzelner Phasen (L1- L3) in Relation zur Absicherung (SL1 - SL3) abrufbar und auf dem Display (ANZ) darstellbar sind.

10. Verfahren zum Betreiben eines Systems nach einem der Ansprüche 1 bis 9, wobei die Hausgeräte vernetzt sind, wobei jedes Hausgerät eine Erkennungseinrichtung einer betreffenden Phase eines Drehstromnetzes der zugrundeliegenden Gebäudeinstallation aufweist, **dadurch gekennzeichnet, dass** die Erkennungseinrichtung folgende Schritte durchführt:
• Herstellung einer gemeinsamen Zeitbasis für alle vernetzten Hausgeräte,
• Auslösung eines Sprungsignals (INT) für alle vernetzten Hausgeräte einschließlich eines vorläufig angeschlossenen Hausgeräts durch eines der Hausgeräte,
• Einleitung eines Zeitmessvorganges ab dem Sprungsignal in Bezug auf eine zuzuordnende positive Flanke eines Impulsverlaufes eines Nulldurchgangssignals einer Phase,
• Auswertung des Messvorganges und Zuordnung der kürzesten Messzeit für die Phase L1, einer mittleren Messzeit für die Phase L2 und einer längsten Messzeit für die Phase L3 und
• Anzeige der Phasenzuordnung in Bezug auf das Hausgerät, von dessen Erkennungseinrichtung der Phasen-Erkennungsvorgang initiiert wurde, um eine phasenbezogene Überlast erkennbar zu machen.

## Claims

1. System of networked household appliances, which comprises a household appliance that is due to be reconnected, which is temporarily connected, wherein each household appliance has an identification facility of a particular phase of a three-phase network of the underlying building installation, **characterised in that** the household appliances (HL1_1 - HL3_n) located in the system (HEMS) have a common time base (CL1_1 - CL3_n), wherein the identification facility (IL1_1 - IL3_n) of each household appliance has a time measuring facility (TI), in order to make it possible to measure a positive edge of a zero crossing (NDG1 - NDG3) of a supply voltage applied to the household appliance in relation to a step signal (INT), which can be transmitted to all household appliances of the system including the temporarily connected household appliance, wherein the identification facility (IL1_1 - IL3_n) has a phase allocator (ZU), which makes it possible to evaluate a result of the time measurement of the time measuring facility (TI) such that the particular phase, to which each household appliance is connected, can be ascertained and displayed (ANZ), in order to make it possible to identify a phase-related overload.

2. System according to claim 1, **characterised in that** the identification facility can be embodied with an interface (IL1_1 - IL3_n) assigned to each household appliance (HL1_1- HL3_n).

3. System according to claim 1 or 2, **characterised in that** the interface units (IL1_1 - IL3_n) of all household appliances are networked together in a wireless or wire-bound or cable-bound manner for data exchange (DAT).

4. System according to claim 3, **characterised in that** the interface units (IL1_1 - IL3_n) are also networked for data exchange (DAT) with a unit (MA) of a system for household appliance management.

5. System according to claim 3 or 4, **characterised in that** a respective clock (CL1_1 - CL3_n) of an interface unit (IL1_1 - IL3_n) can be synchronised in relation to all other clocks (CL1_1 - CL3_n).

6. System according to claim 5, **characterised in that** in order to synchronise the clocks (CL1_1 - CL3_n), a synchronisation algorithm can be used, as corresponds to the Network Time Protocol (NTP) or the Precision Time Protocol (PTP).

7. System according to one of the preceding claims, **characterised in that** an interface unit (IL1_1 - IL3_n) has the time measuring circuit (TI), the allocator circuit (ZU) and the output unit (ANZ) with display, wherein the display has display buttons (DT).

8. System according to claim 7, **characterised in that** the particular phase can be displayed in the display part (ANZ) of an interface unit (IL1_1 - IL3_n) or in the display parts (ANZ) of all interface units (IL1_1 - IL3_n).

9. System according to claim 7 or 8, **characterised in that** predicted values regarding loads of individual phases (L1 - L3) in relation to the fuse (SL1 - SL3) can be retrieved by the display buttons (DT) and shown on the display (ANZ).

10. Method for operating a system according to one of claims 1 to 9, wherein the household appliances are networked, wherein each household appliance has an identification facility of a particular phase of a three-phase network of the underlying building installation, **characterised in that** the identification facility performs the following steps:
• establishing a common time base for all networked household appliances,
• triggering a step signal (INT) for all networked household appliances including a temporarily connected household appliance by way of one of the household appliances,
• introducing a time measurement procedure starting from the jump signal in relation to a positive edge, which is to be allocated, of a pulse progression of a zero crossing signal of a phase,
• evaluating the measurement procedure and allocating the shortest measurement time for the phase L 1, a middle measurement time for the phase L2 and a longest measurement time for the phase L3 and
• displaying the phase allocation in relation to the household appliance, by the identification facility of which the phase identification procedure was initiated, in order to make it possible to identify a phase-related overload.

## Revendications

1. Système d'appareils électroménagers mis en réseau, lequel comporte un appareil électroménager nouvellement en attente d'un raccordement, lequel est raccordé de manière provisoire, dans lequel chaque appareil électroménager comprend un dispositif de détection d'une phase concernée d'un réseau en courant alternatif de l'installation de bâtiment sous-jacente, **caractérisé en ce que** les appareils électroménagers (HL1_1 à HL3_n) se trouvant dans le système (HEMS) présentent une base de temps commune (CL1_1 à CL3_n), dans lequel le dispositif de détection (IL1_1 à IL3_n) de chaque appareil électroménager comprend un dispositif de chronométrage (Tl) afin de rendre mesurable un flanc positif d'un passage par zéro (NDG1 à NDG3) d'une tension d'alimentation appliquée à l'appareil électroménager en relation avec un signal de saut (INT), lequel peut être transmis à tous les appareils électroménagers du système, y compris à l'appareil électroménager raccordé de manière provisoire, dans lequel le dispositif de détection (IL1_1 à IL3_n) comprend un dispositif d'affectation de phases (ZU), lequel rend évaluable un résultat du chronométrage du dispositif de chronométrage (Tl) de telle sorte que la phase exacte à laquelle chaque appareil électroménager est raccordé soit déterminable et affichable (ANZ) afin de rendre détectable une surcharge liée à la phase.

2. Système selon la revendication 1, **caractérisé en ce que** le dispositif de détection peut être configuré avec une interface (IL1_1 à IL3_n) attribuée à chaque appareil électroménager (HL1_1 à HL3_n).

3. Système selon la revendication 1 ou la revendication 2, **caractérisé en ce que** les unités d'interface (IL1_1 à IL3_n) de tous les appareils électroménagers sont mises en réseau sans fil ou par liaison filaire ou par lignes les unes avec les autres pour un échange de données (DAT).

4. Système selon la revendication 3, **caractérisé en ce que** les unités d'interface (IL1_1 à IL3_n) sont également mises en réseau pour un échange de données (DAT) avec une unité (MA) d'un système pour une gestion d'appareils électroménagers.

5. Système selon la revendication 3 ou la revendication 4, **caractérisé en ce qu'**une horloge (CL1_1 à CL3_n) respective d'une unité d'interface (IL1_1 à IL3_n) est synchronisable en relation avec toutes les autres horloges (CL1_1 à CL3_n).

6. Système selon la revendication 5, **caractérisé en ce que**, pour la synchronisation des horloges (CL1_1 à CL3_n), il peut être fait appel à un algorithme de synchronisation tel qu'il corresponde au protocole Network-Time (NTP) ou au protocole Precision-Time (PTP).

7. Système selon l'une des revendications précédentes, **caractérisé en ce qu'**une unité d'interface (IL1_1 à IL3_n) comprend le circuit de chronométrage (TI), le circuit de dispositif d'affectation (ZU) et la partie émission (ANZ) avec écran, dans lequel l'écran comprend des touches d'écran (DT).

8. Système selon la revendication 7, **caractérisé en ce que** la phase exacte est affichable dans la partie affichage (ANZ) d'une unité d'interface (IL1_1 à IL3_n) ou dans les parties affichage (ANZ) de toutes les unités d'interface (IL1_1 à IL3_n).

9. Système selon la revendication 7 ou la revendication 8, **caractérisé en ce que** des valeurs prévisionnelles concernant des contraintes de phases individuelles (L1 à L3) en rapport avec la sécurité (SL1 à SL3) sont accessibles et représentables sur l'écran (ANZ) par l'intermédiaire des touches d'écran (DT).

10. Procédé permettant de faire fonctionner un système selon l'une des revendications 1 à 9, dans lequel les appareils électroménagers sont mis en réseau, dans lequel chaque appareil électroménager comprend un dispositif de détection d'une phase concernée d'un réseau en courant alternatif de l'installation de bâtiment sous-jacente, **caractérisé en ce que** le dispositif de détection met en oeuvre les étapes suivantes :
• élaboration d'une base de temps commune pour tous les appareils électroménagers mis en réseau,
• déclenchement d'un signal de saut (INT) pour tous les appareils électroménagers mis en réseau, y compris un appareil électroménager raccordé de manière provisoire, par l'intermédiaire de l'un des appareils électroménagers,
• lancement d'un processus de chronométrage à compter du signal de saut en relation avec un flanc positif à affecter d'un profil d'impulsion d'un signal de passage par zéro d'une phase,
• évaluation du processus de mesure et affectation du temps de mesure le plus court à la phase L1, d'un temps de mesure moyen à la phase L2 et d'un temps de mesure le plus long à la phase L3 et
• affichage de l'affectation de phases en relation avec l'appareil électroménager par le dispositif de détection duquel le processus de détection de phases a été initié afin de rendre détectable une surcharge liée à la phase.
